# EUROPÄISCHE PATENTSCHRIFT

(11) **EP 1 894 028 B1**
(45) Veröffentlichungstag und Bekanntmachung des Hinweises auf die Patenterteilung: **06.04.2011**
(21) Anmeldenummer: 06763573.0
(22) Anmeldetag: 08.06.2006
(51) Int. Cl.: G01R 31/28, G01R 27/28

(54) **VERFAHREN ZUR ERKENNUNG VON BAUTEILEFEHLERN EINER ANALOGEN SIGNALVERARBEITUNGSSCHALTUNG FÜR EINEN MESSUMFORMER**
METHOD FOR DETECTING COMPONENT FAULTS IN AN ANALOG SIGNAL PROCESSING CIRCUIT FOR A MEASURING TRANSDUCER
PROCEDE D'IDENTIFICATION DES FAUTES DES COMPOSANTS D'UN CIRCUIT ANALOGUE DE TRAITEMENT DE SIGNAUX POUR UN TRANSDUCTEUR DE MESURE

(30) Priorität: 23.06.2005 DE 102005029615
(43) Veröffentlichungstag der Anmeldung: 05.03.2008
(73) Patentinhaber: Endress+Hauser Conducta Gesellschaft für Mess- und Regeltechnik mbH+Co. KG, 70839 Gerlingen (DE)
(72) Erfinder: GEHRKE, Martin, 71384 Weinstadt (DE); FÜSS, Friedrich, 71070 Tübingen (DE)
(74) Vertreter: Andres, Angelika Maria
(86) Internationale Anmeldenummer: PCT/EP2006/062992
(87) Internationale Veröffentlichungsnummer: WO 2006/136497

(56) Entgegenhaltungen:
- WO-A-2004/086069
- GB-A- 967 555
- US-A- 3 643 156
- US-A- 4 458 196
- US-A- 5 315 257
- US-A- 6 037 578
- US-B1- 6 232 834

## Beschreibung

Die Erfindung betrifft ein Verfahren zur Erkennung von Bauteilefehlern einer analogen Signalverarbeitungsschaltung insbesondere für einen Messumformer.

In der Prozessautomatisierungstechnik werden vielfach Sensoren eingesetzt, die zur Erfassung von unterschiedlichen Messgrößen dienen. Die Signale der Sensoren werden Messumformern zugeführt, wo sie geeignet aufbereitet und angezeigt oder über einen Feldbus an eine übergeordnete Einheit weitergeleitet werden. Als Beispiele sind zu nennen Druck- und Temperaturmessumformer, pH-Redoxpotential- Messumformer, Leitfähigkeitsmessumformer etc. für die entsprechende Messgrößen Druck, Temperatur, pH-Wert bzw. Leitfähigkeitswert.

Die Aufgabe eines Sensors ist es, die physikalisch/chemischen Messgröße in ein elektrisches Signal umzuwandeln. Im Messumformer erfolgt eine erste Aufbereitung des anlogen elektrischen Signals. Anschließend wird es in ein digitales Signal umgewandelt und einem Mikrokontroller, in dem die eigentliche Signalverarbeitung stattfindet, zugeführt.

Die für die analoge Signalaufbereitung benötigte Schaltung besteht in der Regel aus einer Leiterkarte mit einer Vielzahl von analogen Bauteilen.

Bei der Fertigung einer solchen Signalaufbereitungsschaltung sind Bestückungsfehler nicht auszuschließen. Hierbei unterscheidet man prinzipiell zwei Fälle. Erstens das betreffende Bauteil ist falsch. D. h. es wurde ein falsches Bauteil bei der Bestückung verwendet. Zweitens das betreffende Bauteil fehlt. D. h. das Bauteil wurde bei der Bestückung vergessen.

Beide Fehlermöglichkeiten haben in der Regel einen erheblichen Einfluss auf die Qualität der Signalverarbeitung und auf das Messergebnis.

Eine Möglichkeit solche Bestückungsfehler auszuschließen besteht darin, nach der Bestückung der Leiterplatte einen Test z. B. einen ICT (in circuit test) durchzuführen. Hierfür müssen auf der Leiterkarte entsprechende Testpunkte bereitgestellt werden.

Durch Anlegen definierter Wechselspannungssignale und Abgriff der resultierenden Signale an einzelnen Testpunkten kann eine analoge Signaturanalyse (ASA) durchgeführt werde. Bei bekannter Impedanz der Bauteile bzw. der Bauteilgruppe kann aus der Strom-Spannungscharakteristik, die auch als Impedanz-Signatur bezeichnet wird, auf fehlerhafte Bauteile geschlossen werden.

Auf Grund der immer größer werdenden Bauteiledichte auf Leiterkarten stehen geeignete Testpunkte häufig nicht mehr zur Verfügung. D. h. solche Leiterkarten sind für ICT-Tests nicht geeignet.

Meist sind für ICT-Tests aufwendige Prüfgeräte mit eingebauten Signalwandlern und einer aufwendigen Signalverarbeitung zur Erfassung und Berechnung der Impedanzen notwendig. Die berechnete Ist-Impedanz wird in einem Prüfprogramm mit der Soll-Impedanz verglichen und eine Abweichung berechnet. Ist diese Abweichung zu groß, wird das betreffende Bauteil als fehlerhaft gemeldet. Ist diese Abweichung

In US 4,458,196 ist ein Verfahren zur Bestimmung von Widerstands-, Induktivitäts- und Kapazitätsparametem in einer Schaltung angeordneter elektronischer Elemente beschrieben. Zur Bestimmung dieser Parameter kann die zu prüfende Schaltung für einen ICT-Test an ein externes Prüfgerät mit einer oder mehreren Testschaltungen und einen Signalprozessor angeschlossen werden.

Aus DE 102 31 180 A1 ist ein Messumformer bekannt, der einen Sensor zur Umwandlung einer damit erfassten Messgröße in ein Sensorsignal aufweist, das in einer Signalaufbereitungseinrichtung zu einem Messsignal aufbereitet wird. Um eine Prüfung der Funktionsfähigkeit des Messumformers ohne Unterbrechung oder Störung des Messvorgangs zu ermöglichen, weist der Messumformer einen steuerbaren Prüfsignalgeber zur Erzeugung eines Prüfsignals auf, welches additiv auf das Sensorsignal aufgeschaltet wird. Bei dem Prüfsignal handelt es sich um ein Spannungssignal, weswegen der Prüfsignalgeber in Reihe mit dem Sensor an die Signalaufbereitungseinrichtung geschaltet ist. Eine Recheneinrichtung prüft anhand von in dem Messsignal enthaltenen Anteilen des Prüfsignals die Funktionsfähigkeit des Messumformers.

Aufgabe der Erfindung ist, ein Verfahren zur Erkennung von Bauteilefehlern einer analogen Signalverarbeitungsschaltung insbesondere für einen Messumformer anzugeben, das die oben genarmiten Nachteile nicht aufweist, das insbesondere einfach und kostengünstig durchführbar ist

Gelöst wird diese Aufgabe durch folgende im Anspruch 1 angegebenen Merkmale.

Vorteilhafte Weiterentwicklungen der Erfindung sind in den Unteransprüchen angegeben.

Die wesentliche Idee der Erfindung besteht darin, dass an einem ersten Testpunkt der Signalverarbeitungsschaltung ein Testsignal erzeugt wird, das am Signalausgang der Signalverarbeitungsschaltung abgegriffen wird und in der Digitaleinheit des Messumformers ausgewertet wird.

Somit sind für das Verfahren keine von extern zugänglichen Testpunkten notwendig.

Aufwendige Prüfgeräte können ebenfalls entfallen. Die Auswertung erfolgt in der ohnehin vorhandenen Digitaleinheit.

Die Einfachheit des Verfahrens zeichnet sich auch dadurch aus, dass das Antwortsignal nur an wenigen ausgewählten Zeitpunkten ausgewertet wird.

Ziel des Verfahrens ist es nicht, fehlerhafte Bauteile auf der Signalvonatetungsschaltung genau zu lokalisieren sondern es soll eine einfache Entscheidung ermöglichen, ob prinzipiell Banteilefehler vodiegen. Die genaue Lokalisierung kann dann in einem weiteren Arbeitsschritt erfolgen oder sie entfällt im Serieneinsatz aus wirtschaftlichen Gründen ganz. Die fehlerhafte Signalveratbeitongsschattung wird dann einfach als defekt entsorgt.

In vorteilhafter Weise ist das Testsignal trapezförmig, da mit den definiert steigenden und fallenden Flanken eines solchen Signals differenzierende Eigenschaften der zu untersuchenden Signalverarbeitungsschaltung einfach geprüft werden können. Der konstante Signalbereich des Signals erlaubt die Überprüfung von integrierenden bzw. verstärkenden Schaltungsteile.

Ein spezielles Beispiel, bei dem das erfindungsgemäße Verfahren einfach angewendet werden kann, ist ein Tiefpassfilter.

Das Verfahren kann auch im Messbetrieb des Sensors durchgeführt werden. Dabei werden die Anteile des Messsignals einfach bei der Auswertung berücksichtigt.

Nachfolgend ist die Erfindung anhand eines in der Zeichnung dargestellten Ausführungsbeispiels näher erläutert.

Es zeigen:
Fig. 1 Blockschaltbild eines Messumformers;
Fig. 2 Prinzipaufbau eines Sensor-Moduls eines Messumformers gemäß Fig. 1;
Fig. 3 Detaildarstellung eines Sensormoduls gemäß Fig. 2;
Fig. 4 Testsignal und Antwortsignal im zeitlichen Verlauf;
Fig. 5 Flussdiagramm der einzelnen Verfahrensschritte des erfindungsgemäßen Verfahrens.

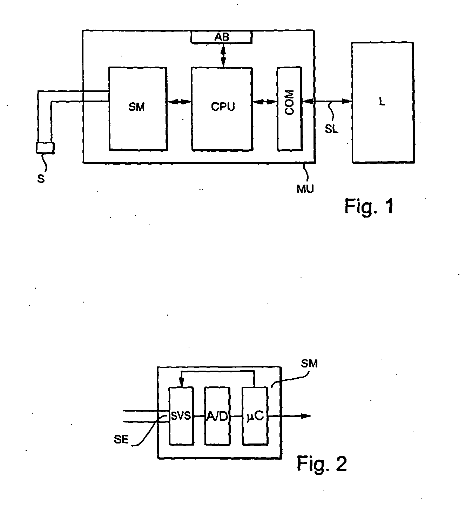

In Fig. 1 ist ein Blockschaltbild eines typischen Messumformers MU für die Prozessautomatisierungstechnik dargestellt. Ein Sensor S, der mit einem Sensormodul SM im Messumformer MU verbunden ist, erfasst z. B. die Temperatur eines Prozessmediums. Im Sensormodul SM erfolgt eine Aufbereitung des analogen Sensorsignals mit einer anschließenden Digitalisierung und Auswertung in einem Mikrocontroller.

Das Sensormodul SM ist mit einem Prozessor-Modul CPU verbunden. Das Prozessor-Modul dient im Wesentlichen der Verrechnung des Sensorsignals mit anderen prozessrelevanten Parametern, der Aufbereitung der Darstellung für eine Anzeige sowie der Weiterleitung der Prozesswerte.

Das Prozessor-Modul CPU ist mit einer Anzeige/Bedieneinheit AB, bestehend aus einem Display und einer Tastatur, verbunden. Weiterhin ist das Prozessor-Modul CPU mit einem Kommunikationsmodul COM verbunden, das einen Anschluss des Messumformers MU an verschiedene Kommunikationssysteme ermöglicht. Beispiele hierfür sind Feldbusse wie z. B. Profibus, Foundation Fieldbus, HART, etc.. Die entsprechenden Signale werden über eine Signalleitung SL übertragen. In der Regel sind Messumformer mit einer übergeordneten Einheit L verbunden. Die übergeordnete Einheit L kann eine Steuerung (SPS) oder ein Leitsystem in einer Warte sein.

In Fig. 2 ist das Sensormodul SM des Messumformers MU als Blockschaltbild dargestellt. Das Sensormodul SM besteht im Wesentlichen aus einer Signalverarbeitungsschaltung SVS, einem Analog/Digitalwandler AD und einem Mikrocontroller µC.

Über einen Signaleingang SE wird das analoge Messsignal des Sensors S der Signalverarbeitungsschaltung SVS zugeführt.

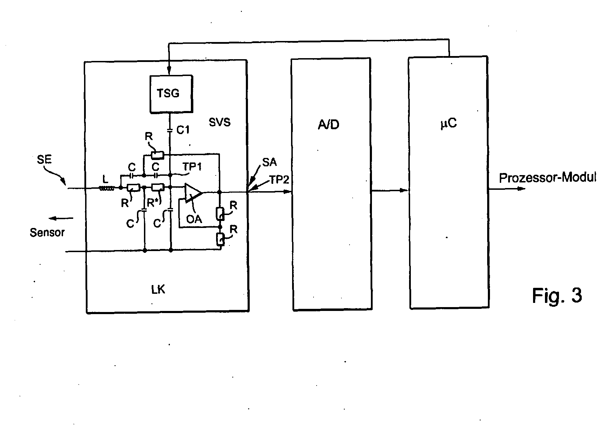

Die Signalverarbeitungsschaltung SVS ist in Fig. 3 als Teil des Sensormoduls SM näher dargestellt. Sie weist als analoge Bauteile mehrere Widerstände R, mehrere Kondensatoren C, eine Spule L und einen Operationsverstärker OA auf, die auf einer Leiterkarte LK angeordnet sind, auf. Zusätzlich befindet sich noch ein Testsignalgenerator TSG auf der Leiterkarte LK. Die Signalverarbeitungsschaltung SVS dient zur analogen Aufbereitung des Messsignals MS. Bei der Signalverarbeitungsschaltung SVS handelt es sich um eine Filterschaltung auf deren Einzelheiten jedoch nicht eingegangen werden soll. In Messumformern werden je nach Sensortyp unterschiedliche Signalverarbeitungsschaltungen eingesetzt.

Das aufbereitete Messsignal wird über einen Signalausgang SA von der Signalverarbeitungsschaltung SVS zu einem Analog/Digitalwandler AD geführt. Nach der Digitalisierung des aufbereiteten Messsignals wird das digitalisierte Messsignal in einem Mikrocontroller µC weiter verarbeitet und anschließend dem Prozessor-Modul CPU zugeleitet.

Über den Testsignalgenerator TSG, der vom Mikrocontroller µC angesteuert wird, kann ein Testsignal TS über einen Kondensator C1 kapazitiv an einem Testpunkt TP1 der Signalverarbeitungsschaltung SVS eingekoppelt werden.

Das dem Testsignal TS zugeordnete Antwortsignal AS wird über den Signalausgang SA, der als zweiter Testpunkt TP2 dient, dem A/D Wandler und anschließend dem Mikrocontroller µC zur Auswertung zugeführt.

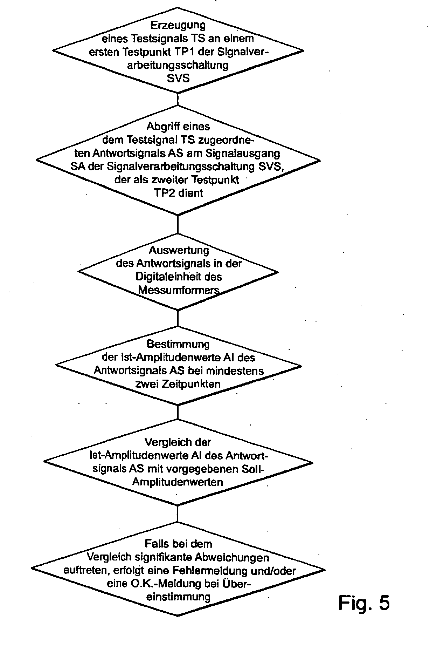

Nachfolgend ist das erfindungsgemäße Verfahren anhand des in Fig. 5 dargestellten Flussdiagrams näher erläutert. Am Testpunkt TP1 wird das im Testsignalgenerator TSG erzeugte Testsignal TS in die Signalverarbeitungsschaltung SVS eingekoppelt (Verfahrensschritt a).

Aus Fig. 3 ist ersichtlich, dass der Testpunkt TP1 nicht direkt mit dem Signaleingang SE verbunden ist. Das dem Testsignal TS zugeordneten Antwortsignal AS wird am Signalausgang SA, dem Testpunkt TP2, erfasst (Verfahrensschritt b).

Ausgewertet wird das Antwortsignal AS nach seiner Digitalisierung im Mikrocontroller µC als Digitaleinheit (Verfahrensschritt c). Zur Auswertung werden die Amplituden des Antwortsignals AS bei mindestens zwei bestimmten Zeitpunkten T1 und T2 bestimmt. Die Ist-Amplitudenwerte AI1 bzw. AI2 zu den Zeitpunkten T1 bzw. T2 werden mit Soll-Amplitudenwerten AS und AS2 für die entsprechenden Zeitpunkte T1 T2 verglichen. Hierzu müssen die entsprechenden Sollwerte im Mikrocontroller µC abgespeichert sein. Falls eine signifikante Abweichung besteht wird eine Fehlermeldung generiert und/oder eine O.K-Meldung bei Übereinstimmung (Verfahrensschritt e).

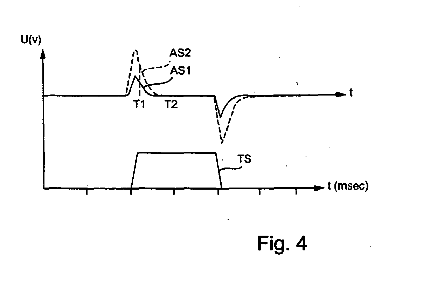

In Fig. 4 sind als spezielles Testsignal ein trapezförmiges Testsignal TS und zwei verschiedene Antwortsignale AS dargestellt. Aufgetragen sind die Spannung U als Funktion der Zeit t. Diese Signale könnten, wenn die entsprechenden Testpunkte zugänglich sind, so mit einem Oszillographen aufgenommen werden.

Das Antwortsignal AS 1 zeigt das zu erwartende Antwortsignal bei intakter und richtig bestückter Signalverarbeitungsschaltung SVS. Ist z. B. der mit einem Stern gekennzeichnet Widerstand R fehlerhaft bestückt z. B. anstatt 680 kΩ nur 86 kΩ und so wird man als Antwortsignal das gestrichelt dargestellte Signal AS2 erhalten. Deutlich ist der Unterschied in den Signalen AS1, AS2 zu sehen. Sind die Soll-Amplitudenwerte des Antwortsignals AS im Mikrocontroller µC gespeichert, so kann einfach durch Vergleiche der Ist-Amplitudenwerte AI mit den Soll-Amplitudenwerten AS ermittelt werden, ob Bauteile der Signalverarbeitungsschaltung SVS fehlerhaft bestückt wurden.

Bei signifikanten Abweichungen wird eine entsprechende Fehlermeldung generiert und/oder eine O.K-Meldung bei Übereinstimmung.

Häufig reicht der Vergleich der Amplitudenwerte bereits bei zwei Zeitpunkten aus. Ein Vergleich bei mehr Zeitpunkten erhöht den Rechenaufwand, kann aber eine höhere Zuverlässigkeit des Verfahrens zur Folge haben.

Die Wahl des Testsignals TS und des Testpunkts TP1 muss jeweils der Signalverarbeitungsschaltung SVS angepasst sein. Es gibt Testpunkte an denen die Einkopplung des Testsignals TS sinnvoller bzw. weniger sinnvoll ist.

Selbstverständlich kann das Testsignal auch während des Betriebs des Messumformers erzeugt und ausgewertet werden. Hierzu muss nur der entsprechende Anteil des Messsignals am Antwortsignal berücksichtigt
werden.

Die Erfindung umfasst auch eine elektronische Baugruppe, die eine
Vorrichtung zur Ausführung des Verfahrens enthält.

## Patentansprüche

1. Verfahren zur Erkennung von Bauteilefehlern einer analogen Signalverarbeitungsschaltung (SVS) für einen Messumformer, die zur Signalaufbereitung eines analogen Messsignals dient, das nach seiner Aufbereitung einer nachgeschalteten Digitaleinheit zur weiteren Signalverarbeitung zugeführt wird
wobei die Signalverarbeitungsschaltung (SVS) aus einer Leiterkarte (LK) mit einer Vielzahl von analogen Bauteilen besteht, **gekennzeichnet durch** folgende Verfahrensschritte:
Erzeugung eines Testsignals (TS) an einem ersten Testpunkt (TP1) der Signalverarbeitungsschaltung (SVS) mittels eines auf der Leiterkarte (LK) angeordneten Testsignalgenerators (TSG),
Abgriff eines dem Testsignal (TS) zugeordneten Antwortsignals (AS) am Signalausgang (SA) der Signalverarbeitungsschaltung (SVS), der als zweiter Testpunkt (TP2) dient,
Auswertung des Antwortsignals (AS) in der Digitaleinheit des Messumformers,
Bestimmung der ist-Amplitudenwerte (AI) des Antwortsignals (AS) bei mindestens zwei Zeitpunkten,
Vergleich der Ist-Amplitudenwerte (AI) des Antwortsignals (AS) mit vorgegebenen Soll-Amplitudenwerten,
wobei falls bei dem Vergleich signifikante Abweichungen auftreten, eine Fehlermeldung erfolgt und/oder eine O.K-Meldung bei Übereinstimmung erfolgt.

2. Verfahren nach einem der vorhergehenden Ansprüche, **dadurch gekennzeichnet, dass** das Testsignal (TS) trapezförmig ist.

3. Verfahren nach einem der vorhergehenden Ansprüche, **dadurch gekennzeichnet, dass** die Signalverarbeitungsschaltung (SVS) ein Tiefpassfilter ist.

4. Verfahren nach einem der vorhergehenden Ansprüche, **dadurch gekennzeichnet, dass** das Verfahren im Betrieb der Signalverarbeitungsschaltung (SVS) durchgeführt wird.

## Claims

1. Process for detecting component errors of an analog signal processing circuit (SVS) for a transmitter which is used for the signal preparation of an analog measuring signal which is fed to a downstream digital unit for further signal processing after signal preparation,
where the signal processing circuit (SVS) comprises a printed circuit board (LK) with many analog components, **characterized by** the following process steps:
- Generation of a test signal (TS) at a first test point (TP1) of the signal processing circuit (SVS) using a test signal generator (TSG) arranged on the printed circuit board (LK)
- Measurement of a response signal (AS) - assigned to the test signal (TS) - at the signal output (SA) of the signal processing circuit (SVS) that serves as a second test point (TP2).
- Evaluation of the response signal (AS) in the digital unit of the transmitter
- Determination of the actual amplitude values (AI) of the response signal (AS) at two points in time at least
- Comparison of the actual amplitude values (AI) of the response signal (AS) with predefined target amplitude values
where an error message is generated if the comparison identifies significant deviations in the values and/or an OK message is displayed if the values match.

2. Process as per one of the previous claims, **characterized in that** the test signal (TS) is trapezoidal.

3. Process as per one of the previous claims, **characterized in that** the signal processing circuit (SVS) is a low-pass filter.

4. Process as per one of the previous claims, **characterized in that** the process is performed when the signal processing circuit (SVS) is in operation.

## Revendications

1. Procédé destiné à l'identification d'erreurs des composants d'un circuit de traitement de signaux analogiques (SVS) pour un transmetteur, qui sert au traitement d'un signal analogique, lequel est acheminé, après son traitement, à une unité numérique aval pour traitement ultérieur
le circuit de traitement de signaux analogiques (SVS) étant constitué d'une carte de circuit imprimé (LK) comportant un grand nombre de composants analogiques, **caractérisé par** les étapes de procédé suivantes :
Génération d'un signal de test (TS) sur un premier point test (TP1) du circuit de traitement de signaux analogiques (SVS) au moyen d'un générateur de signaux de test (TSG) disposé sur la carte de circuit imprimé (LK),
Prélèvement d'un signal de réponse (AS) attribué au signal de test (TS) sur la sortie signal (SA) du circuit de traitement de signaux analogiques (SVS), laquelle sert de deuxième point test (TP2),
Interprétation du signal de réponse (AS) dans l'unité numérique du transmetteur,
Détermination des valeurs d'amplitude réelles (AI) du signal de réponse (AS) pour au moins deux instants,
Comparaison des valeurs d'amplitude réelles (AI) du signal de réponse (AS) avec les valeurs d'amplitudes théoriques prédéfinies,
Un message d'erreur étant émis au cas où des écarts significatifs apparaîtraient lors de la comparaison, et/ou un message OK étant émis en cas de concordance.

2. Procédé selon l'une des revendications précédentes, **caractérisé en ce que** le signal de test (TS) est de forme trapézoïdale.

3. Procédé selon l'une des revendications précédentes, **caractérisé en ce que** le circuit de traitement de signaux analogiques (SVS) est un filtre passe-bas.

4. Procédé selon l'une des revendications précédentes, **caractérisé en ce que** le procédé est exécuté pendant le fonctionnement du circuit de traitement de signaux analogiques (SVS).
